# EUROPEAN PATENT SPECIFICATION

(11) **EP 3 812 783 B1**
(45) Date of publication and mention of the grant of the patent: **27.11.2024**
(21) Application number: 19204756.1
(22) Date of filing: 23.10.2019
(51) Int. Cl.: G01R 31/389, G01R 31/367

(54) **ESTIMATING A BATTERY STATE FROM ELECTRICAL IMPEDANCE MEASUREMENTS USING CONVOLUTIONAL NEURAL NETWORK MEANS**
SCHÄTZUNG EINES BATTERIEZUSTANDS AUS ELEKTRISCHEN IMPEDANZMESSUNGEN UNTER VERWENDUNG VON NEURONALEN FALTUNGSNETZWERKMITTELN
ESTIMATION DE L'ÉTAT D'UNE BATTERIE À PARTIR DE MESURES D'IMPÉDANCE ÉLECTRIQUE À L'AIDE DE MOYENS DE RÉSEAU NEURONAL CONVOLUTIONNEL

(43) Date of publication of application: 28.04.2021
(73) Proprietor: Novum engineerING GmbH, 01067 Dresden (DE)
(72) Inventor: Boß, Valentin, 01127 Dresden (DE)
(74) Representative: Ter Meer Steinmeister & Partner

(56) References cited:
- WO-A1-2019/021095
- WO-A1-2019/021099
- WO-A1-2019/181728
- WO-A2-03/071617
- US-A1- 2013 307 487
- US-A1- 2018 067 169
- US-A1- 2020 153 264

## Description

The invention relates to a computer-implemented method of estimating a battery state of an electrochemical battery. Furthermore, the invention relates to a battery state estimating system for estimating a battery state of an electrochemical battery.

For example, the computer may be a microcontroller. For example, the computer or microcontroller may include a processing unit, a memory, and input/output ports.

WO 2005/059579 A1 and EP 1702219 B1 describe an apparatus and a method for estimating a state of charge of a battery by using a neural network. The apparatus includes a sensing section for detecting current, voltage and a temperature from a battery cell and a neural network performing a neural network algorithm and a learning algorithm based on data of the current, voltage and temperature transmitted thereto from the sensing section and present time data. In an example, a dynamic multi-dimensional wavelet neural network includes an input field, a hidden layer and an output layer.

US 4678998 A describes a battery condition monitor and a monitoring method.

JP 2003-249271 A and JP 4038788 B2 describe the determining of a deterioration state and a residual capacity of a battery in real time. In an example, as an operation parameter of the battery under operation, a measurement unit can measure and sample periodically the voltage of the battery, the current, the internal impedance, and the temperature. The internal impedance of the battery is measured by adding an AC signal of 1 kHz and 100 mA to the battery. A first neural network can decide on a deterioration state as "normal", "caution", and "degradation", based on the operation parameter of the battery from the measurement unit, and a second neural network can decide on the residual capacity based on the operation parameter of the battery and the deterioration state from the first neural network. Each of the first and second neural networks is a three-layer feedforward network having an input layer, an intermediate layer, and an output layer.

US 6307378 B1 describes a method and an apparatus for measurement of electrochemical cell and battery impedances.

WO 03/071617 A2 describes a method for determining a condition parameter of an electrochemical cell, such as in a battery. In an example, measurement signals such as terminal voltages, cell voltages, load current, charging current, ambient temperature, battery surface temperature, terminal temperature, internal battery temperature, and impedance signals are passed to a feature extraction processing algorithm, which generates a feature vector and a feature flag. Data from the feature vector is passed to a neural network ISOC predictor for initial battery capacity state of charge estimation, and a neural network CSOC predictor for continuous prediction of SOC during operation. In another example, the information contained in a feature vector is used by a neural network SOH classifier, a linear/statistical SOH classifier, and a fuzzy logic SOH classifier for state of health classification. The neural network designed for direct SOC estimation uses one hidden layer.

WO 2016/208745 A1 and its translation DE 112016002873 T5 describe a method of recognizing the state of charge or depth of discharge of a battery. The method includes determining the complex impedance between the positive and negative electrodes of a battery with respect to a plurality of frequencies.

WO 2017/110437 A1 and its translation DE 11 2016 003 789 T5 describe an estimation device that estimates the residual capacity of a lithium ion battery.

WO 2016/080111 A1 and its translation DE 11 2015 005 201 T5 describe an estimation device for estimating a remaining stored power amount of a storage battery

US 2013/0307487 A1 and US 8994340 B2 describe a method and a system for determining the temperature of cells in a battery pack, without using temperature sensors, by measuring the impedance of the cells and using the impedance to determine the temperature.

WO 00/16083 and EP 1129343 B1 describe a device that measures real and imaginary parts of complex immittance of a cell or battery at n discrete frequencies. The device determines cell/battery properties by evaluating components of an equivalent circuit model.

WO 2019/021099 A1 describes a method of operation for a power storage system that has a storage battery, a first circuit that can measure impedance, and a neural network, the method involving: a first step in which the charging or discharging of the storage battery is suspended; a second step in which the open-circuit voltage of the storage battery is measured; a third step in which the impedance of the storage battery is measured; a fourth step in which the measured open-circuit voltage and impedance are inputted to an input layer of the neural network; a fifth step in which a first signal is outputted from an output layer. The first signal corresponds to an estimated value for the discharge capacity of the storage battery. In an example, between adjacent layers, a convolution neural network (CNN) may be used.

US 2018/0067169 A1 describes a battery capacity measuring device that measures the battery capacity of a rechargeable battery and includes an impedance measurement unit.

WO 2019/021095 A1 relates to a system for controlling charging of a secondary cell and a method for detecting abnormality in a secondary cell.

WO 2019/181728 A1 relates to a degradation estimating device for an energy storing device.

### Summary of the Invention

It is an object of the invention to provide a novel method of estimating a battery state of an electrochemical battery based on electrical impedance measurements. It is desirable that the method makes better use of information included in a series of electrical impedance measurements for different measurement frequencies.

The invention is indicated in the independent claims. Further embodiments are indicated in the dependent claims.

According to one aspect of the invention, there is provided a computer-implemented method of estimating a battery state of an electrochemical battery, the method comprising:
providing a series of electrical impedance measurements of an electrochemical battery, each electrical impedance measurement being measured at a respective measurement frequency, the series being ordered according to the respective measurement frequencies,
determining a battery state of the electrochemical battery using artificial convolutional neural network means configured to receive as inputs a series of electrical impedance values,
wherein a series of electrical impedance values is provided to the artificial convolutional neural network means, the series of electrical impedance values corresponding to the provided series of electrical impedance measurements,
wherein the artificial convolutional neural network means receives and processes the provided series of electrical impedance values to generate therefrom at least one output signal representing a battery state associated with the electrochemical battery,
wherein the artificial convolutional neural network means receives and processes the series of electrical impedance values to generate therefrom at least one output signal representing a state of charge of the electrochemical battery.

The series of electrical impedance values corresponds to the provided series of electrical impedance measurements. That is, both series characterize a same curve progression of the electrical impedance in the complex plane over the index of elements of the respective series. Herein, the term "complex plane", unless specified otherwise, is to be understood as the complex plane of electrical impedance.

In particular, the series of electrical impedance values is provided based on the provided series of electrical impedance measurements.

For example, the provided series of electrical impedance values may be identical to or may be included in the provided series of electrical impedance measurements, or may be generated from the provided series of electrical impedance measurements.

For example, generating the series of electrical impedance values from the provided series of electrical impedance measurements may include at least one of interpolating between electrical impedance measurements, selecting from the electrical impedance measurements, and extrapolating the electrical impedance measurements.

The artificial convolutional neural network means may receive and process the series of electrical impedance values to generate therefrom the output signal in accordance with a predetermined processing structure of the artificial convolutional neural network means.

The artificial convolutional neural network means includes a convolutional neural network (CNN).

A CNN has an input layer, at least one convolutional layer, and an output layer. A CNN may be a deep neural network. A CNN may be trained for identifying patterns in the transformed series of electrical impedance measurements and associating the patterns with respective battery states.

For example, the artificial convolutional neural network means may have been trained to estimate a battery state of a (rechargeable) electrochemical battery by detecting characteristic features of a series of electrical impedance values, using training data for temperatures of a predetermined temperature range, and for different states of health and/or different states of charge of the batteries.

Due to the convolution performed within the convolutional layer(s) of a convolutional neural network, a convolutional neural network is particularly suited for recognizing patterns that occur in the input vector or input array. Convolutional neural networks are known for classifying images, for example.

It has been found that a convolutional neural network, due to its pattern identifying capability, is suitable for estimating a battery state associated with the electrochemical battery, based on a series of electrical impedance values which corresponds to a series of electrical impedance measurements, the series being ordered according to the respective measurement frequencies.

In contrast, in the prior art of WO 03/071617 A2, the neural network designed for direct SOC estimation uses one hidden layer, and data from several different measurement signals are included in the feature vector, or are passed to a feature extraction processing algorithm that generates the feature vector; the data include electrical parameters such as battery voltage and current, and a temperature. Consequently, WO 03/071617 A2 does not disclose applying a convolution to such data of a feature vector.

Preferably, the electrochemical battery is a rechargeable electrochemical battery.

Estimating a battery state in the form of the state of charge is highly relevant, for example, for mobile appliances such as mobile tools or mobile, electrically driven apparatuses, such as vehicles.

Similarly, an estimation of a battery state in the form of the state of health is of high importance with respect to a reliability of a device.

For many applications, in particular of a rechargeable electrochemical battery, knowledge of a battery state in the form of the battery temperature of an electrochemical battery is of high importance, as well.

By estimating a battery state of the battery using the artificial convolutional neural network means, the battery state is estimated based on the provided series of electrical impedance measurements (that is, based on the corresponding series of electrical impedance values). In particular, the battery state may be estimated based solely on values that correspond to direct measurements such as direct electrical measurements, for example, solely on the provided series of electrical impedance measurements.

The electrical impedance may also be termed a complex electrical impedance and may be a complex number and may be provided being expressed in a unit of electrical resistance, for example, ohm.

For example, each electrical impedance measurement of the provided series of electrical impedance measurements may be or include a complex number that defines a real part and an imaginary part of the respective electrical impedance. The electrical impedance may also be represented in polar form, defining a magnitude (or amplitude) and an angle (or phase). For example, the electrical impedance measurements of the provided series of electrical impedance measurements may be in the form of respective complex representations (complex numbers). Or, for example, the electrical impedance measurements may each be in the form of amplitude and phase, and the step of providing may comprise converting the electrical impedance measurements into electrical impedance measurements in the form of respective complex representations of the electrical impedance measurements. A "complex representation" of an electrical impedance measurement comprises a complex number. For example, the complex representation of an electrical impedance measurement may be a complex number.

Herein, the term "battery" is to be understood as including a battery cell. The battery may include one or more battery cells. In particular, the term "battery" includes a battery cell as well as a battery composed of multiple battery cells.

Specifically, the electrochemical battery is understood as defining a device consisting of one or more electrochemical cells with external electrical connections. For example, the battery may include two external electrical connections for drawing power from the one or more electrochemical cells and, in case of a rechargeable electrochemical battery, for (recharging the one or more electrochemical cells.

For example, the respective measurement frequency may be a frequency of a signal input to the electrochemical battery. For example, the signal may be a sinusoidal signal.

Preferably, each electrical impedance value of the provided series of electrical impedance values comprises a complex number that defines a real part and an imaginary part of a respective electrical impedance.

The elements of the series of electrical impedance values are fed to corresponding inputs of the artificial convolutional neural network means. Thus, an automated battery state estimation based on the provided series of electrical impedance values is made possible.

Preferably, the series of electrical impedance measurements are provided in the form of a digital signal.

Preferably, the series of electrical impedance measurements of the electrochemical battery are provided in a digitally represented form.

The series of electrical impedance measurements may be received from an electrical impedance measuring unit or electrical impedance measuring means, for example.

Providing the series of electrical impedance measurements may comprise receiving the electrical impedance measurements of the series one after another.

The series of electrical impedance measurements may be communicated to a battery state estimating system comprising means for carrying out the steps of the method. The system may be configured for providing (including receiving) the communicated electrical impedance measurements.

In one or more embodiments, the measurement frequencies are assumed to be logarithmically equidistantly spaced. Preferably, the measurement frequencies are logarithmically equidistantly spaced over at least four decades of the measurement frequency range (the frequency range of the measurement frequencies), more preferably over at least five decades of the measurement frequency range.

Preferably, the measurement frequencies include a measurement frequency in the range of 0.1 to 1.0 Hz.

Preferably, the measurement frequencies include a measurement frequency in the range of 1 kHz to 10 kHz.

Preferably, the measurement frequencies include at least 4 (four) measurement frequencies per decade of the measurement frequency range, more preferably at least five measurement frequencies per decade of the measurement frequency range.

The step of providing the series of electrical impedance measurements may comprise receiving a plurality of electrical impedance measurements, each electrical impedance measurement being measured at a respective measurement frequency, and:
- arranging the plurality of electrical impedance measurements according to the associated measurement frequencies to provide the series of electrical impedance measurements, or
- providing the plurality of the electrical impedance measurements as the series of electrical impedance measurements.

For example, the arranged plurality of electrical impedance measurements, optionally including the respective measurement frequencies, may be provided as the series of electrical impedance measurements.

The plurality of electrical impedance measurements, or the series of electrical impedance measurements may be received in the form of an electrical impedance spectrum.

In the series of electrical impedance measurements, for example, the electrical impedance measurements may include the respective measurement frequencies. For example, each electrical impedance measurement may include the measured value of the electrical impedance and the measurement frequency. However, the electrical impedance measurements may as well be in the form of respective electrical impedances, represented as respective complex numbers, or each represented as an amplitude and phase.

An output signal is generated that represents a battery state associated with the electrochemical battery. For example, the at least one output signal may represent a classification and/or an estimation of a battery state.

The battery state includes a state of charge (SoC) of the electrochemical battery and may include at least one of a state of health (SoH) of the electrochemical battery, a state of function (SoF) of the electrochemical battery, a capacity of the electrochemical battery, and a temperature of the electrochemical battery.

For example, the output signal may be transmitted or communicated or output to an output unit for outputting the signal, and/or for outputting a visual signal based on the output signal. The visual signal may be displayed.

Preferably, the provided series of electrical impedance values has a predetermined number of elements. For example, the number of elements may correspond to a number of inputs of the artificial convolutional neural network means for receiving the series of electrical impedance values.

For example, generating the series of electrical impedance values from the provided series of electrical impedance measurements may include adjusting the number of elements of the series of electrical impedance measurements to the predetermined number of elements.

For example, the series of electrical impedance values may be generated from the provided series of electrical impedance measurement by adjusting the number of elements of the series of electrical impedance measurements to the predetermined number of elements.

For example, the method may comprise: if the number of elements of the provided series of electrical impedance measurements is different from the predetermined number of elements, adjusting the number of elements of the series of electrical impedance measurements to the predetermined number of elements.

In one or more embodiments, the method may comprise adjusting the number of elements of the series of electrical impedance measurements or adjusting the number of elements of the series of electrical impedance values to a predetermined number of elements.

Thus, the number of elements may be adjusted to a corresponding number of inputs of the artificial convolutional neural network means for receiving the series of electrical impedance values.

For example, the predetermined number of elements may be the predetermined number of elements of the series of electrical impedance values.

For example, the number of elements of the series of electrical impedance values may be adjusted to a predetermined number of elements by adjusting the number of elements of the series of electrical impedance measurements to the predetermined number of elements.

For example, adjusting the number of elements of the series of electrical impedance measurements or the number of elements of the series of electrical impedance values may comprise at least one of interpolating between electrical impedance measurements, selecting from the electrical impedance measurements, and extrapolating the electrical impedance measurements. In the adjusting step, the number of elements may be increased, maintained, or decreased.

According to the claimed invention, the artificial convolutional neural network means receives and processes the series of electrical impedance values to generate therefrom at least one output signal representing a state of charge of the electrochemical battery.

In one or more embodiments, the artificial convolutional neural network means receives and processes the series of electrical impedance values to further generate therefrom at least one output signal representing a state of health of the electrochemical battery.

In one or more embodiments, the artificial convolutional neural network means receives and processes the series of electrical impedance values to further generate therefrom at least one output signal representing a state of function of the electrochemical battery.

In one or more embodiments, the artificial convolutional neural network means receives and processes the series of electrical impedance values to further generate therefrom at least one output signal representing a temperature of the electrochemical battery.

In one or more embodiments, the method further comprises:
calculating electrical impedance gradients from the series of electrical impedance measurements to generate a series of electrical impedance gradients,
wherein the artificial convolutional neural network means is configured to receive as further inputs the series of electrical impedance gradients,
wherein the artificial convolutional neural network means receives and processes at least the provided series of electrical impedance values and the series of electrical impedance gradients to generate therefrom the at least one output signal representing a state of charge of the electrochemical battery.

Thus, a series of electrical impedance gradients may be provided for evaluation by the artificial convolutional neural network means, which gradients emphasize information about the variation of the electrical impedance dependent on the measurement frequency.

For example, electrical impedance gradients of the series of electrical impedance measurements may be calculated with respect to the measurement frequency, with respect to a logarithm of the measurement frequency, or with respect to the index of the elements of the series of measurements. That is, a respective gradient at a respective index of the elements of the series of measurements may be calculated as the change in electrical impedance per change of the measurement frequency, per change of the logarithm of the measurement frequency, or per change of the index of the elements of the series of measurements.

For example, for a respective element of the series of electrical impedance measurements, a corresponding gradient may be calculated to express the change in the value of the electrical impedance measurements per change in the measurement frequency, per change in a logarithm of the measurement frequency, or per change in the index of elements, at the respective measurement frequency, the logarithm thereof, or at the respective index of elements. Thus, the gradient may be calculated for a series of discrete electrical impedance measurements. Calculating the gradient may correspond to differentiating a continuous electrical impedance curve with respect to the measurement frequency, or with respect to the logarithm of measurement frequency or the index of elements of the series of measurements. For example, for a respective element of the series of electrical impedance measurements, a corresponding gradient may be calculated based on a difference between the element and a neighboring element of the series of electrical impedance measurements, divided by the difference in the respective indices of elements or in the respective measurement frequencies.

For example, calculating gradients of the series of electrical impedance measurements may include calculating gradients of the real part and gradients of the imaginary part of the series of electrical impedance measurements.

In one or more embodiments, the method comprises:
measuring the electrical impedance of an electrochemical battery at different measurement frequencies to provide the series of electrical impedance measurements, using electrical impedance measuring means.

For example, the series of electrical impedance measurements may be provided based on the measured electrical impedance at the different measurement frequencies.

The electrical impedance measurements may be measured in any order and/or concurrently for the respective measurement frequencies.

For example, the electrical impedance measuring means may be configured to input a signal including a respective frequency to the electrochemical battery, and determine a ratio of amplitude and phase of a response signal of the same frequency to the amplitude and phase of the input signal, the frequency of the signal and of the response signal corresponding to the measurement frequency.

For example, the electrical impedance measuring means may be electrical impedance spectroscopy measuring means configured for measuring electrical impedance of an electrochemical battery at a series of measurement frequencies. That is, the electrical impedance of the electrochemical battery is measured according to a process of electrochemical impedance spectroscopy.

Using electrochemical impedance spectroscopy, electrochemical processes in the electrochemical battery are characterized by electrical measurements that characterize the AC response of the electrochemical battery to an applied AC signal. The chemical processes in the battery, in addition to the structural configuration and the configuration of the connectors, lead to characteristic frequency dependencies of the measured impedance.

During the measurement of an electrical impedance at a specific measurement frequency, a DC offset signal (an offset voltage or an offset current) or DC bias signal may be applied to the battery, which is modulated by the AC signal of the measurement frequency.

For example, the series of electrical impedance measurements may be provided from an independent measuring circuit or electrical impedance measuring means. However, a battery state estimating system may as well include electrical impedance measuring means for measuring and providing the series of electrical impedance measurements from an electrochemical battery.

For example, the electrochemical battery may be a lithium-ion battery or a lead-acid battery.

According to an aspect of the invention, there may be provided a computer-implemented method of monitoring a battery state of an electrochemical battery. The monitoring method may include the steps of the method of estimating a battery state.

For example, the method may be implemented in a battery monitoring system for monitoring a battery state of an electrochemical battery.

For example, the method may be implemented in a battery charging system for recharging a rechargeable electrochemical battery.

According to an aspect of the invention, there is provided a battery state estimating system for estimating a battery state of an electrochemical battery, the system comprising means for carrying out the steps of the method.

For example, the system may be or may be comprised in a system for monitoring a battery state of an electrochemical battery.

For example, the system may be or may be comprised in a battery charging system for recharging a rechargeable electrochemical battery.

In one or more embodiments, the battery state estimating system further comprises electrical impedance measuring means configured for measuring the electrical impedance of an electrochemical battery at different measurement frequencies to provide the series of electrical impedance measurements.

Preferred embodiments of the invention will now be described in conjunction with the drawings, in which:
Fig. 1 is a schematic illustration of a method of estimating a battery state of a rechargeable electrochemical battery;
Fig. 2 is a schematic graph showing series of electrical impedance measurements of a rechargeable electrochemical battery measured at respective measurement frequencies and at respective battery temperatures;
Fig. 3 is a schematic graph showing series of electrical impedance measurements of a rechargeable electrochemical battery measured at respective measurement frequencies and at respective states of health of a battery;
Fig. 4 is a schematic illustration of determining a gradient of the electrical impedance; and
Fig. 5 is a schematic illustration of a system for estimating a battery state of a rechargeable electrochemical battery.

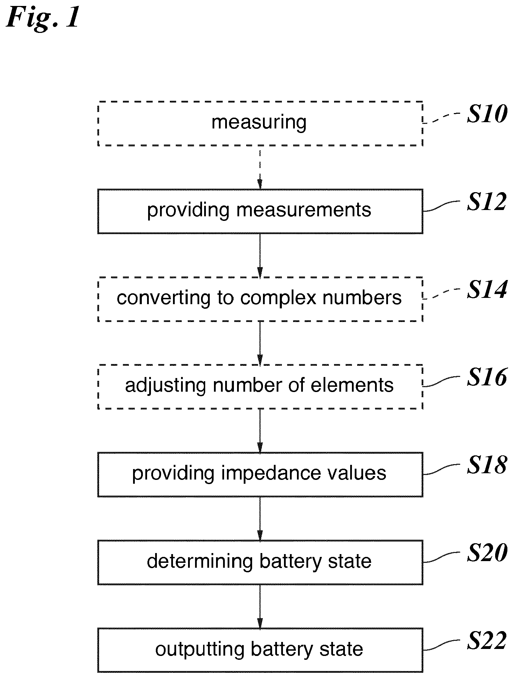

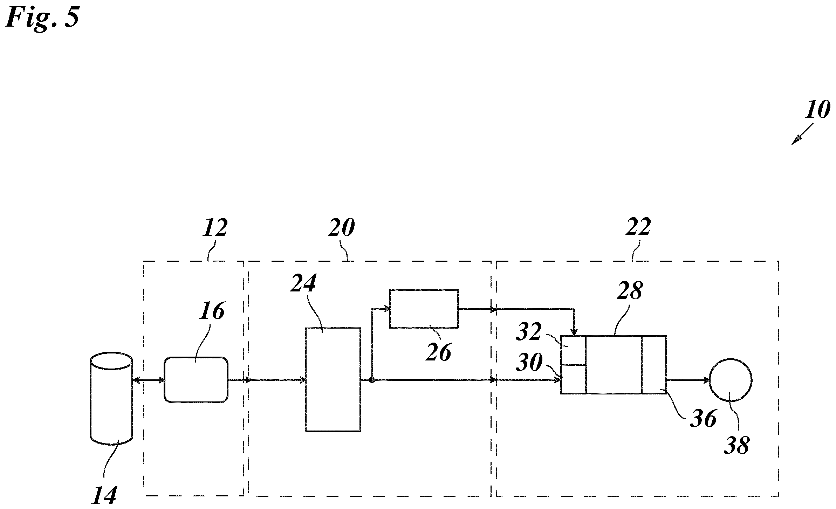

Fig. 1 schematically shows a computer-implemented method of estimating a battery state of a rechargeable electrochemical battery, for example, a lithium-ion battery. For example, the method may be performed by a battery state estimating system as described further below with respect to Fig. 5.

Step S10 is a step of measuring the electrical impedance of the electrochemical battery at different measurements frequencies, using electrical impedance measuring means.

From measuring the electrical impedance, in step S12, a series of electrical impedance measurements of the electrochemical battery is provided in form of a digital signal, for example, as a data set. The series is ordered according to the respective measurement frequencies, preferably in the order of increasing measurement frequencies.

However, the method may also start with step S12 of providing the measurements, which may have been measured independently from the method, and may have been communicated to a computer performing the method.

In case the provided electrical impedance measurements are not yet in the form of complex numbers (representing complex impedance), the method may include an optional step S14 of converting the provided electrical impedance measurements to complex numbers.

In an optional step S16, the number of elements of the series of electrical impedance measurements is adjusted to a predetermined number of elements, for example, to a number of 21 elements.

In step S18, the series of electrical impedance measurements is provided as a series of electrical impedance values to artificial convolutional neural network means, configured to receive as inputs the series of electrical impedance values.

In step S20, the artificial convolutional neural network means process the series of electrical impedance values to generate therefrom an output signal representing a battery state. Thus, a battery state of the electrochemical battery is determined, based on the series of electrical impedance values. In step S22, the battery state is output. For example, the battery state may be a state of health of the battery.

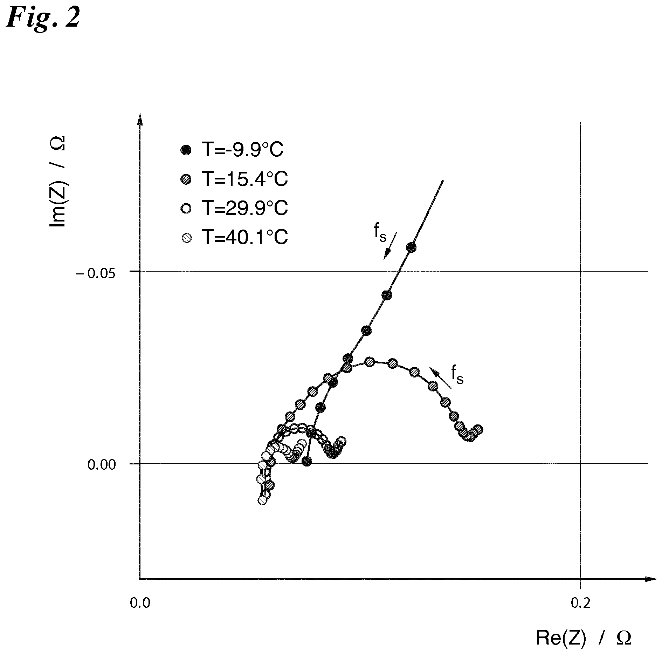

Fig 2 exemplarily shows four series of electrical impedance measurements measured at respective temperatures T of a battery. Each series includes electrical impedance measurements measured at respective measurement frequencies fₛ. The measurements of each series are indicated by circles having respective patterns.

Fig. 2 is a Nyquist diagram in the form of a two-dimensional graph of the imaginary part Im(Z) and the real part Re(Z) of the electrical impedance Z. For illustration purposes, the elements of the series are connected by a line. According to convention, the imaginary part is displayed in an inversed direction, with the imaginary part increasing towards the bottom of Fig. 2. In Fig. 2, an arrow fₛ exemplarily shows the order of the measurements with increasing measurements frequency fₛ.

Preferably, the measurements are taken at logarithmically progressing measurement frequencies. Preferably, the series of measurements comprises at least 4 (four) measurements per decade of the measurement frequency range. In Fig. 2, the electrical impedance measurements of the series of electrical impedance measurements are schematically indicated for illustration purposes, only. The number of measurements illustrated in Fig. 2 may deviate from the number of measurements that are actually used, and is for illustration purposes, only.

As Fig. 2 illustrates, for different temperatures T, the curves of the series of electrical impedance measurements in the complex plane show a large variation. Generally, the variation is highly non-linear with respect to the temperature T.

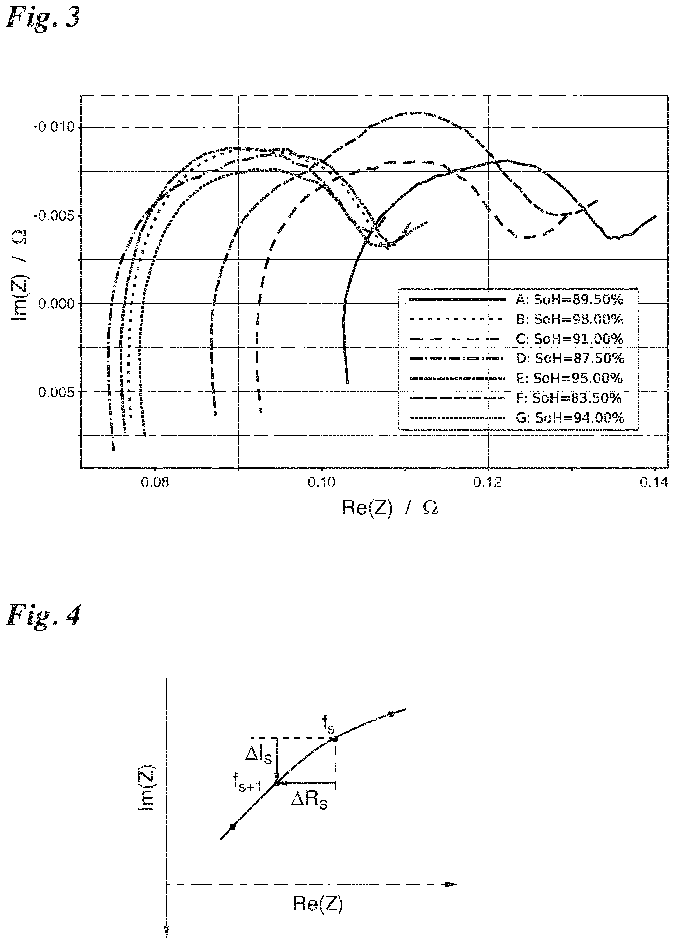

The multiple series of measurements shown in Fig. 2 correspond to different temperatures but equal or similar states of health and equal or similar states of charge of the battery. However, as shown in Fig. 3, different series A to G of electrical impedance measurements are provided for different states of health (SoH), at a same or similar temperature and same or similar state of charge. Fig. 3 schematically shows series of electrical impedance measurements measured at different states of health of a battery. The series are schematically shown by continuous lines.

Thus, the curve progression of the electrical impedance measurements varies in dependency on the temperature as well as the state of health of the battery.

In addition to the series of electrical impedance values, a series of electrical impedance gradients may be provided as further inputs to the artificial convolutional neural network means.

Fig. 4 schematically shows a part of a series of electrical impedance measurements, which are connected by a line. The series includes a first measurement taken at a measurement frequency fₛ, and a second measurement taken at a measurement frequency fₛ₊₁., wherein s and s+1 denote the respective indices of the series of measurements. The real part and the imaginary part of the difference between the measurements are indicated as ΔRₛ, ΔIₛ.

For the respective measurement frequency fₛ, the electrical impedance gradient with respect to the measurement frequency is calculated as follows: the real part of the electrical impedance gradient is calculated as: ΔRₛ/(fₛ₊₁-fₛ); the imaginary part of the electrical impedance gradient is calculated as: ΔIₛ/(fₛ₊₁-fₛ).

Thus, gradients of the series of electrical impedance measurements with respect to the measurement frequency are calculated.

In a further embodiment, the gradients may be calculated with respect to the index s of the elements of the series of measurements as follows: the real part of the electrical impedance gradient may be calculated as: ΔRₛ/((s+1)-s) = ΔRₛ; the imaginary part of the electrical impedance gradient may be calculated as: ΔIₛ/((s+1)-s) = ΔIₛ.

In a still further embodiment, the gradients may be calculated with respect to a logarithm of the measurement frequency as follows: the real part of the electrical impedance gradient is calculated as: ΔRₛ/(log_{B}(fₛ₊₁)- log_{B}(fₛ)); the imaginary part of the electrical impedance gradient is calculated as: ΔIₛ/(log_{B}(fₛ₊₁)- log_{B}(fₛ)); wherein log_{B} is the logarithm to the base B; for example, B=10.

Fig. 5 schematically shows an example of a battery state estimating system 10 configured for performing the method of Fig. 1, the system optionally including electrical impedance measuring means 12. For example, the battery state estimating system 10 may be implemented in a computer, such as a microcontroller. For example, the microcontroller including the system 10 and, optionally, the electrical impedance measuring means 12 may be part of a battery monitoring system for monitoring a battery state of an electrochemical battery 14.

The electrical impedance measuring means 12 includes an electrical impedance measuring unit 16. The battery state estimating system 10 further includes a pre-processing unit 20 and computational means 22.

For a series of measurement frequencies fₛ, the electrical impedance measuring unit 12 applies an excitation signal, for example a sinusoidal signal of the respective measurement frequency fₛ, to an electrochemical battery 14 that is to be measured. The signal is input in the form of a small amplitude alternating current (AC) signal, and the alternating current response from the battery 14 is measured. For example, a current signal is input, and a voltage response signal is measured. Alternatively, a voltage signal is input, and a current response signal is measured. During the measurements, a direct current (DC) bias voltage or DC bias current may be applied in accordance with the type of the electrochemical battery 14. The measuring setup corresponds to electrochemical impedance spectroscopy (EIS) measurement setups known as such. The measurement frequencies are arranged or increased in equidistant steps on a logarithmic scale, for the respective measurements, in accordance with a measurement setup that is predetermined for the electrochemical battery 14.

The measured electrical impedance at a specific measurement frequency is the ratio of the amplitude and phase of the AC response signal to the amplitude and phase of the input signal and is represented as a complex number (complex impedance). For example, four different measurements frequencies may be used per decade of the measurement frequencies.

The pre-processing unit 20 includes standardizing means 24 for providing the series of electrical impedance measurements from the electrical impedance measurement means 12 and for adjusting the number of elements of the series of electrical impedance measurements to a predetermined number of elements, for example, 21 elements. For example, the number of elements may be adjusted by interpolating the elements of the series. In case that the series of electrical impedance measurements provided by the standardizing means 24 already has the target value of the predetermined number of elements, the standardizing means 24 maintains the number of elements.

The preprocessing unit 20 further includes gradient calculating means 26 that receive the standardized series of electrical impedance measurements from the standardizing means 24. The gradient calculating means 26 calculate gradients of the series of electrical impedance measurements with respect to the measurement frequency to generate a series of electrical impedance gradients, similar to what has been explained above with respect to Fig. 4. Thus, the gradient calculating means 26 generate a series of electrical impedance gradients from the standardized series of electrical impedance measurements.

The computational means 22 include artificial convolutional neural network means 28 having first input means 30 for receiving the standardized series of electrical impedance measurements from the pre-processing unit 20 as a series of electrical impedance values.

Furthermore, the artificial convolutional neural network means 28 has second input means 32 for receiving the series of electrical impedance gradients from the gradient calculating means 26.

For example, the series of electrical impedance values and the series of electrical impedance gradients together may form an input (such as an input vector or input array)of the artificial neural network means 28.

Furthermore, the artificial convolutional neural network means 28 include output means 36 for outputting an output signal 38 representing a battery state, for example, a state of health, associated with the electrochemical battery 14. The artificial convolutional neural network means 28 receives and processes the series of electrical impedance values and the series of electrical impedance gradients and generates therefrom the output signal.

The artificial convolutional neural network means 28 has been trained to estimate the battery state 38 of the electrochemical battery 14 by detecting characteristic features of the series of electrical impedance values and the series of electrical impedance gradients. The determined battery state 38 is output by the output means 36.

The system may also be implemented with the artificial convolutional neural network means 28 having only the first input means 30 for receiving the standardized series of electrical impedance measurements. In this case, preferably, the pre-processing unit 20 does not include the gradient calculating means 26.

## Claims

1. A computer-implemented method of estimating a battery state of an electrochemical battery, the method comprising:
providing (S12) a series of electrical impedance measurements of an electrochemical battery (14), each electrical impedance measurement being measured at a respective measurement frequency (fₛ), the series being ordered according to the respective measurement frequencies (fₛ),
determining (S20) a battery state of the electrochemical battery (14) using artificial convolutional neural network means (28) configured to receive as inputs a series of electrical impedance values,
wherein a series of electrical impedance values is provided to the artificial convolutional neural network means (28), the series of electrical impedance values corresponding to the provided series of electrical impedance measurements,
wherein the artificial convolutional neural network means (28) receives and processes the provided series of electrical impedance values to generate therefrom at least one output signal representing a battery state (38) associated with the electrochemical battery (14),
**characterized in that**
the artificial convolutional neural network means (28) receives and processes the series of electrical impedance values to generate therefrom at least one output signal representing a state of charge of the electrochemical battery (14).

2. The method of claim 1, wherein the method further comprises:
adjusting (S16) the number of elements of the series of electrical impedance measurements to a predetermined number of elements.

3. The method of any one of the preceding claims, wherein the artificial convolutional neural network means (28) receives and processes the series of electrical impedance values to further generate therefrom at least one output signal representing a state of health of the electrochemical battery (14).

4. The method of any one of the preceding claims, wherein the artificial convolutional neural network means (28) receives and processes the series of electrical impedance values to further generate therefrom at least one output signal representing a state of function of the electrochemical battery (14).

5. The method of any one of the preceding claims, wherein the artificial convolutional neural network means (28) receives and processes the series of electrical impedance values to further generate therefrom at least one output signal representing a temperature associated with the electrochemical battery (14).

6. The method of any one of the preceding claims, wherein the method further comprises:
calculating electrical impedance gradients from the series of electrical impedance measurements to generate a series of electrical impedance gradients,
wherein the artificial convolutional neural network means (28) is configured to receive as further inputs the series of electrical impedance gradients,
wherein the artificial convolutional neural network means (28) receives and processes at least the provided series of electrical impedance values and the series of electrical impedance gradients to generate therefrom the at least one output signal representing a state of charge of the electrochemical battery (14).

7. The method of any one of the preceding claims, wherein the method further comprises:
measuring (S 10) the electrical impedance of an electrochemical battery (14) at different measurement frequencies (fₛ) to provide the series of electrical impedance measurements.

8. A battery state estimating system for estimating a battery state of an electrochemical battery (14), the system comprising means for carrying out the steps of the method of any one of claims 1 to 7.

9. The battery state estimating system of claim 7, the battery state estimating system further comprising:
electrical impedance measuring means (12) configured for measuring the electrical impedance of an electrochemical battery (14) at different measurement frequencies (fₛ) to provide the series of electrical impedance measurements.

## Patentansprüche

1. Ein computer-implementiertes Verfahren zum Schätzen eines Batteriezustands einer elektrochemischen Batterie, das Verfahren umfassend:
Zurverfügungstellen (S12) einer Reihe von Messungen der elektrischen Impedanz einer elektrochemischen Batterie (14), wobei jede Messung der elektrischen Impedanz bei einer jeweiligen Messfrequenz (fₛ) gemessen wird und wobei die Reihe nach den jeweiligen Messfrequenzen (fₛ) geordnet ist,
Bestimmen (S20) eines Batteriezustands der elektrochemischen Batterie (14) unter Verwendung eines künstlichen Convolutional-Neural-Network-Mittels (28), das eingerichtet ist, als Eingaben eine Reihe von Werten der elektrischen Impedanz zu empfangen,
wobei dem künstlichen Convolutional-Neural-Network-Mittel (28) eine Reihe von Werten der elektrischen Impedanz zur Verfügung gestellt wird, wobei die Reihe von Werten der elektrischen Impedanz der zur Verfügung gestellten Reihe von Messungen der elektrischen Impedanz entspricht,
wobei das künstliche Convolutional-Neural-Network-Mittel (28) die zur Verfügung gestellte Reihe von Werten der elektrischen Impedanz empfängt und verarbeitet, um daraus wenigstens ein Ausgabesignal zu erzeugen, das einen Batteriezustand (38) repräsentiert, der mit der elektrochemischen Batterie (14) assoziiert ist,
**dadurch gekennzeichnet, dass**
das künstliche Convolutional-Neural-Network-Mittel (28) die Reihe von Werten der elektrischen Impedanz empfängt und verarbeitet, um daraus wenigstens ein Ausgabesignal zu erzeugen, das einen Ladezustand der elektrochemischen Batterie (14) repräsentiert.

2. Das Verfahren nach Anspruch 1, wobei das Verfahren weiter umfasst:
Anpassen (S16) der Anzahl der Elemente der Reihe von Messungen der elektrischen Impedanz an eine vorbestimmte Anzahl von Elementen.

3. Das Verfahren nach einem der vorherigen Ansprüche, wobei das künstliche Convolutional-Neural-Network-Mittel (28) die Reihe von Werten der elektrischen Impedanz empfängt und verarbeitet, um daraus weiter wenigstens ein Ausgabesignal zu erzeugen, das einen Gesundheitszustand der elektrochemischen Batterie (14) repräsentiert.

4. Das Verfahren nach einem der vorherigen Ansprüche, wobei das künstliche Convolutional-Neural-Network-Mittel (28) die Reihe von Werten der elektrischen Impedanz empfängt und verarbeitet, um daraus weiter wenigstens ein Ausgabesignal zu erzeugen, das einen Funktionszustand der elektrochemischen Batterie (14) repräsentiert.

5. Das Verfahren nach einem der vorherigen Ansprüche, wobei das künstliche Convolutional-Neural-Network-Mittel (28) die Reihe von Werten der elektrischen Impedanz empfängt und verarbeitet, um daraus weiter wenigstens ein Ausgabesignal zu erzeugen, das eine Temperatur repräsentiert, die mit der elektrochemischen Batterie (14) assoziiert ist.

6. Das Verfahren nach einem der vorherigen Ansprüche, wobei das Verfahren weiter umfasst:
Berechnen von Gradienten der elektrischen Impedanz aus der Reihe von Messungen der elektrischen Impedanz, um eine Reihe von Gradienten der elektrischen Impedanz zu erzeugen,
wobei das künstliche Convolutional-Neural-Network-Mittel (28) eingerichtet ist, als weitere Eingaben die Reihe von Gradienten der elektrischen Impedanz zu empfangen,
wobei das künstliche Convolutional-Neural-Network-Mittel (28) zumindest die zur Verfügung gestellte Reihe von Werten der elektrischen Impedanz und die Reihe von Gradienten der elektrischen Impedanz empfängt und verarbeitet, um daraus das wenigstens eine Ausgabesignal zu erzeugen, das einen Ladezustand der elektrochemischen Batterie (14) repräsentiert.

7. Das Verfahren nach einem der vorherigen Ansprüche, wobei das Verfahren weiter umfasst:
Messen (S10) der elektrischen Impedanz einer elektrochemischen Batterie (14) bei unterschiedlichen Messfrequenzen (fₛ), um die Reihe von Messungen der elektrischen Impedanz zur Verfügung zu stellen.

8. Ein Batteriezustands-Schätzsystem zum Schätzen eines Batteriezustands einer elektrochemischen Batterie (14), wobei das System Mittel zum Ausführen der Schritte des Verfahrens nach einem der Ansprüche 1 bis 7 umfasst.

9. Das Batteriezustands-Schätzsystem nach Anspruch 7, wobei das Batteriezustands-Schätzsystem weiter aufweist:
elektrische Impedanz-Messmittel (12), eingerichtet zum Messen der elektrischen Impedanz einer elektrochemischen Batterie (14) bei verschiedenen Messfrequenzen (fₛ), um die Reihe von Messungen der elektrischen Impedanz zur Verfügung zu stellen.

## Revendications

1. Procédé d'estimation d'un état de batterie d'une batterie électrochimique, mis en oeuvre par ordinateur, le procédé comportant les étapes consistant à :
fournir (S12) une série de mesures d'impédance électrique d'une batterie électrochimique (14), chaque mesure d'impédance électrique étant mesurée à une fréquence de mesure (fₛ) respective, la série étant ordonnée en fonction des fréquences de mesure (fₛ) respectives,
déterminer (S20) un état de batterie de la batterie électrochimique (14) en utilisant des moyens de réseau neuronal convolutif artificiel (28) configurés pour recevoir en tant qu'entrées une série de valeurs d'impédance électrique,
dans lequel une série de valeurs d'impédance électrique est fournie aux moyens de réseau neuronal convolutif artificiel (28), la série de valeurs d'impédance électrique correspondant à la série fournie de mesures d'impédance électrique,
dans lequel les moyens de réseau neuronal convolutif artificiel (28) reçoivent et traitent la série fournie de valeurs d'impédance électrique pour générer à partir de celle-ci au moins un signal de sortie représentant un état de batterie (38) associé à la batterie électrochimique 14),
**caractérisé en ce que**
les moyens de réseau neuronal convolutif artificiel (28) reçoivent et traitent la série de valeurs d'impédance électrique (32) pour générer à partir de celle-ci au moins un signal de sortie représentant un état de charge de la batterie électrochimique (14).

2. Procédé selon la revendication 1, dans lequel le procédé comporte en outre l'étape consistant à :
ajuster (S16) le nombre d'éléments de la série de mesures d'impédance électrique à un nombre d'éléments prédéterminé.

3. Procédé selon l'une quelconque des revendications précédentes, dans lequel les moyens de réseau neuronal convolutif artificiel (28) reçoivent et traitent la série de valeurs d'impédance électrique pour générer en outre à partir de celle-ci au moins un signal de sortie représentant un état de santé de la batterie électrochimique (14).

4. Procédé selon l'une quelconque des revendications précédentes, dans lequel les moyens de réseau neuronal convolutif artificiel (28) reçoivent et traitent la série de valeurs d'impédance électrique pour générer en outre à partir de celle-ci au moins un signal de sortie représentant un état de fonctionnement de la batterie électrochimique (14).

5. Procédé selon l'une quelconque des revendications précédentes, dans lequel les moyens de réseau neuronal convolutif artificiel (28) reçoivent et traitent la série de valeurs d'impédance électrique pour générer en outre à partir de celle-ci au moins un signal de sortie représentant une température associée à la batterie électrochimique (14).

6. Procédé selon l'une quelconque des revendications précédentes, dans lequel le procédé comporte en outre l'étape consistant à :
calculer des gradients d'impédance électrique à partir de la série de mesures d'impédance électrique pour générer une série de gradients d'impédance électrique,
dans lequel les moyens de réseau neuronal convolutif artificiel (28) sont configurés pour recevoir en tant qu'entrées supplémentaires la série de gradients d'impédance électrique,
dans lequel les moyens de réseau neuronal convolutif artificiel (28) reçoivent et traitent au moins la série fournie de valeurs d'impédance électrique et la série de gradients d'impédance électrique pour générer à partir de celles-ci le au moins un signal de sortie représentant un état de charge de la batterie électrochimique (14).

7. Procédé selon l'une quelconque des revendications précédentes, dans lequel le procédé comporte en outre l'étape consistant à :
mesurer (S10) l'impédance électrique d'une batterie électrochimique (14) à différentes fréquences de mesure (fₛ) pour fournir la série de mesures d'impédance électrique.

8. Système d'estimation d'état de batterie pour estimer un état de batterie d'une batterie électrochimique (14), le système comportant des moyens pour exécuter les étapes du procédé selon l'une quelconque des revendications 1 à 7.

9. Système d'estimation d'état de batterie selon la revendication 7, le système d'estimation d'état de batterie comportant en outre :
des moyens de mesure d'impédance électrique (12) configurés pour mesurer l'impédance électrique d'une batterie électrochimique (14) à différentes fréquences de mesure (fₛ) pour fournir la série de mesures d'impédance électrique.
